Europäisches Patentamt

European Patent Office

Office européen des brevets

(11) Veröffentlichungsnummer: **0 394 678**
**A2**

(12) # EUROPÄISCHE PATENTANMELDUNG

(21) Anmeldenummer: **90105640.8**

(22) Anmeldetag: **24.03.90**

(51) Int. Cl.5: **H05K 3/46**

(30) Priorität: **28.04.89 DE 3914727**

(43) Veröffentlichungstag der Anmeldung:
**31.10.90 Patentblatt 90/44**

(84) Benannte Vertragsstaaten:
**BE CH DE ES FR GB IT LI LU NL SE**

(71) Anmelder: **SCHERING AKTIENGESELLSCHAFT**
**Berlin und Bergkamen**
**Müllerstrasse 170/78**
**D-1000 Berlin 65(DE)**

(72) Erfinder: **Altendorf, Ludwig**
**Mozartstrasse 25**
**D-4795 Delbrück(DE)**

(54) **Mehrlagen-Leiterplatten für Feinleiter und Verfahren zu ihrer Herstellung.**

(57) Die Erfindung betrifft Mehrlagen-Leiterplatten für Feinleiter, dadurch gekennzeichnet, daß diese aus mindestens einem Mehrschicht-Laminat mit folgendem Schichtaufbau bestehen:

a) Innenlage

b) Auf der Innenlage aufgebrachtem harzimprägnierten Glasgewebe (Prepreg)

c) Auf dem Prepeg aufgebrachter Polyvinylfluoridfolie

d) Auf der Folie aufgebrachtem Zwischenblech

EP 0 394 678 A2

Die Erfindung betrifft Mehrlagen-Leiterplatten für Feinleiter und Verfahren zu ihrer Herstellung.

Die erfindungsgemäßen Mehrlagen-Leiterplatten sollen die weitere Entwicklung derartiger Leiterplatten zu feineren Leiterbahnbreiten ermöglichen. Außerdem soll eine im Mikrobereich glatte, von Eindrücken freie, Prepregoberfläche sichergestellt werden.

Mehrlagen-Leiterplatten sind bereits bekannt. Diese stellen Weiterentwicklungen von gedruckten Schaltungen dar, um höhere Packungsdichten und bessere Verbindungen der elektrischen Bauelemente zu ermöglichen. Mehrlagen-Leiterplatten besitzen nach dem Stand der Technik je nach der Anzahl der Schaltungesebenen aus einer oder mehreren Innenlagen, die entweder untereinander oder durch Abdeckung mit Schutz- und Druckfolien durch Verpressen unter Druck- und Temperaturanwendung miteinander verbunden werden.

In der Regel legt man hierbei ein oder zwei Prepreg zwischen die Innenlagen und zwischen eine nach außen abschließende Kupferfolie. Üblicherweise handelt es sich um eine speziell präparierte Kupferfolie von 35 $\mu$ beziehungsweise 17.5 $\mu$, mit der die Haftungs- beziehungsweise Abschälfähigkeiten der Leiterzüge und metallisierten Flächen erzielt werden.

Die weitere Entwicklung der Multilayer zu feineren Leiterbahnbreiten erfordert nun aus Gründen der Unterätzung die Verwendung ultradünner Kupferfolien für die Außenlagen. Ab Leiterbahn breiten $< = 100\ \mu$ ist die Verwendung der bisherigen 17,5 $\mu$ Folie zunächst nicht mehr möglich, da die Unterätzung bereits bei 100 breiten Leiterbahnen ca. 40% der nominellen Breite beträgt. Die Herstellung derartiger ultradünner Kupferfolien sowie deren weitere Verarbeitung ist jedoch außerordentlich aufwendig und nur mit wesentlich erhöhten Produktionskosten möglich.

Der Erfindung liegt die Aufgabe zugrunde, Mehrlagenleiterplatten zur Verfügung zu stellen, welche frei von Kupferfolien sind.

Diese Aufgabe wird erfindungsgemäß durch Mehrlagen-Leiterplatten gemäß dem kennzeichnenden Teil des Patentanspruchs gelöst.

Weitere Ausgestaltungen der Erfindung sind den Kennzeichnungsteilen der Unteransprüche zu entnehmen.

Die erfindungsgemäßen Mehrlagen-Leiterplatten haben gegenüber dem Stand der Technik den Vorteil des Wegfalls der Außenlagen Kupferfolien. Ein weiterer Vorteil liegt in der Verwendung einer Polyvinylfluoridfolie, die in Verbindung mit den Zwischenblechen beim Preßpaketaufbau eine im Mikrobereich glatte, von Eindrücken freie, Prepregoberfläche sicherstellt.

Die Polyvinylfluoridfolie wirkt gleichzeitig als Trennmittel zwischen Prepreg und Zwischenblech und sichert die Entnahme des verpreßten Multilayers aus dem Preßwerkzeug.

Dieses Preßpaket wird mit weiteren Preßpaketen, die über Zwischenbleche voneinander getrennt sind, in einem Preßwerkzeug zusammengefaßt und nach bekannten Abläufen verpreßt.

Für die Weiterverarbeitung der bereits verpreßten Mehrlagen-Leiterplatten werden vor der Metallisierung vorzugsweise die für die Aufnahme von Bauteilanschlußstiften oder für die Durchkontaktierungen vorgesehenen Bohrungen angebracht, die dann zusammen mit den Außenflächen vorbehandelt, bekeimt und metallisiert werden.

Eine Ausführungsform besteht darin, die Epoxidharzoberfläche zunächst einem oxidativen Aufrauhschritt durch Ätzmittel wie zum Beispiel Chromsäure, ein Chromsäure-enthaltendes Mittel oder Permanganatlösungen zu unterwerfen. Um einen gleichmäßigen Angriff des Ätzmediums zu erreichen, kann die Epoxidharzoberfläche vorzugsweise zunächst mit einem organischen Quellmittel, wie zum Beispiel Dimethylsulfoxid, 1-Methyl-3-pyrrolidon, Dimethylacetamid, Dimethylformammid, Dimethylacetal oder anderen wässrigen oder nicht wässrigen Lösungen in Kontakt gebracht werden. Nach dem Ätzangriff wird vorzugsweise ein Neutralisations- beziehungsweise Reduktionsschritt zur Entfernung noch anhaftender Restoxidantien angeschlossen. Danach wird in der traditionnellen Bohrlochmetallisierungstechnik üblichen Weise konditioniert, bekeimt und metallisiert. Für die Metallisierung kommen insbesondere Kupfer und Nikkel als Metall in Betracht.

Wird die Additivtechnik bevorzugt, so muß vor oder unmittelbar nach der Bekeimung der Epoxidharzoberfläche ein bildgebendes Verfahren, wie Siebdruck oder ein phototechnisches Verfahren in Negativtechnik eingeschoben werden. Die Metallisierung erfolgt dann ausschließlich an den durch das bildgebende Verfahren vorgegebenen Stellen, wo Leiterbahnstrukturen oder Lötplätze erwünscht sind. Eine Metallabscheidung erfolgt in der mit herkömmlichen autokatalytisch abscheidenden Metallisierungsbädern, vorzugsweise stromlos abscheidenden Kupferbädern, bis zur gewünschten Endschichtstärke. Bei Verwendung der Semiadditivtechnik wird nach der Bekeimung der Epoxidharzoberfläche zunächst ganzflächig mit einem autokatalytisch abscheidenden Metallisierungsbad, zum Beispiel einem Kupfer- oder Nickelbad, dünn metallisiert. Anschließend kann dieser erste Metallfilm in einem galvanischen Metallisierungsbad weiter verstärkt werden. Man erhält einem zum Beispiel 3-5 $\mu m$ dicken Metallüberzug, der in der Folge einem bildgebenden Verfahren unterworfen wird, so daß die späteren Leiterzug- oder Lötplatzstrukturen im Negativverfahren hergestellt werden.

In den Galvanoresistkanälen wird anschließend das Leiterbild in der bevorzugten Ausführungsform in einem galvanisch arbeitenden Bad bis zur endgültigen Metallschichtdicke ausgebaut. Als Metalle können zum Beispiel Kupfer oder Nickel zum Einsatz kommen. Nach der Entfernung des Galvanoresists werden die Metallpartien, die nur dünn aufgebaut wurden, durch Differenzätzen entfernt. Alternativ kann auch vor der Entfernung des Galvanoresists ein Ätzresist galvanisch oder stromlos aufgebracht werden. Zum Einsatz können Zinn/Blei-, Zinn-, Blei-, Nickel-, Nickel/Gold-, Palladium/Nickel-Schichten oder deren Schichtkombinationen zum Einsatz kommen. Bei der Herstellung der Innenlagen wird als Endschicht die freiliegende Kupferschicht zu Kupferoxid oxidiert, um Schwarz- oder Braunoxid zu ergeben. Alternativ kann auch stromlos verzinnt werden.

Die Vorteile der neuen Mehrlagen-Leiterplatten (Multilayer und Packlayer) Multilayer-Herstellmethode sind insbesondere:
- Leiterbahnbreiten und Feinleiterstrukturen < = 100 $\mu$ sind mit vernachlässigbarer Unterätzung herstellbar
- Reduzierung der Herstellkosten durch Entfall der Außenlagen - Kupfer - Folie
- Einsparung von Chemikalienkosten beim Ätzprozeß der Außenlagen, durch die nach dem neuen Verfahren aufgebrachte reduzierte Kupferschichtstärke
- Reduzierung der Abwasseraufbereitung und Entsorgungskosten durch Reduzierung des Ätzprozesses der Außenlagenerstellung
Weitere qualitative Vorteile:
- Handling ultradünner Kupferfolie bei Zusammenstellung des Preßpaketes entfällt
- Umfassende sofortige Kontrolle der Passergenauigkeit des Bohrbildes Ausführungsbeispiele der Erfindung und der Stand der Technik sind in den Zeichnungen dargestellt.

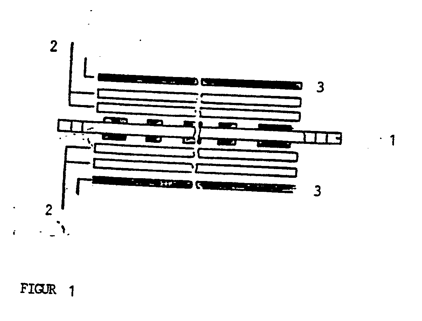

Figur 1 zeigt das Schnittbild einer Mehrlagen-Leiterplatte nach dem Stand der Technik.

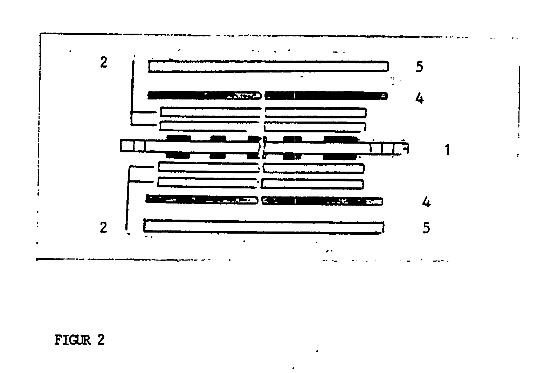

Figur 2 zeigt ein Schnittbild der erfindungsgemäßen Mehrlagen-Leiterplatte (Multilayer).

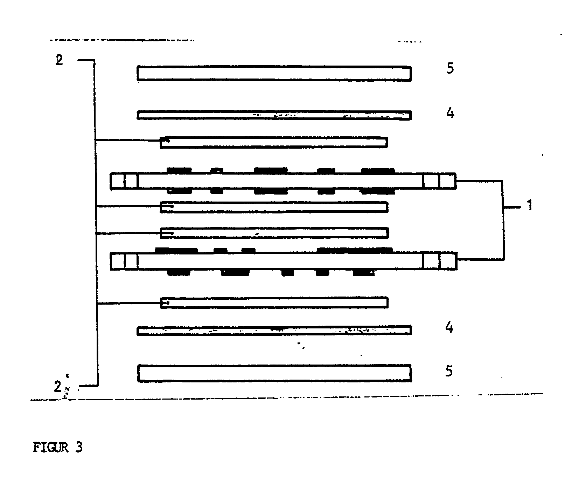

Figur 3 zeigt eine vorteilhafte Anwendung der beschriebenen Methode. Der unter Figur 2 dargestellte Multilayer ist als Packlayer ausgebildet. Damit kann auf die normal übliche Lötstopmaske verzichtet werden.

Hierin bedeuten:
1 = Innenlage
2 = Prepreg
3 = Kupfer-Folie
4 = Polyvinylfluoridfolie
5 = Zwischenblech

**Ansprüche**

1. Mehrlagen-Leiterplatten für Feinleiter, dadurch gekennzeichnet, daß diese aus mindestens einem Mehrschicht-Laminat mit folgendem Schichtaufbau bestehen:
a) Innenlage
b) Auf den Innenlage aufgebrachtem harzimprägnierten Glasgewebe (Prepreg)
c) Auf dem Prepeg aufgebrachter Polyvinylfluoridfolie
d) Auf der Folie aufgebrachtem Zwischenblech

2. Mehrlagen-Leiterplatten nach Anspruch 1, dadurch gekennzeichnet, daß die Schicht a) aus zwei Innenlagen besteht, die durch eine Schicht b) voneinander getrennt sind.

3. Mehrlagen-Leiterplatten nach Anspruch 1 oder 2, dadurch gekennzeichnet, daß die Innenlage nach dem Substraktiv-Verfahren erstellt ist.

4. Mehrlagen-Leiterplatten nach Anspruch 1 oder 2, dadurch gekennzeichnet, daß zusätzlich Schichten b), c) und d) zum Aufbau eines symmetrischen Laminats vorgesehen werden.

5. Mehrlagen-Leiterplatten nach Anspruch 1, daß als äußere Schicht der Leiterplatte eine Schicht b) vorgesehen ist.

6. Verfahren zur Metallisierung von Mehrlagen-Leiterplatten gemäß Ansprüchen 1 bis 5, dadurch gekennzeichnet, daß die Oberflächen der Leiterplatten zunächst mit einem organischen Quellmittel vorbehandelt werden, die nach Einwirkung eines Ätzmittels aktiviert und anschließend chemisch und gegebenenfalls galvanisch metallisiert werden.

7. Verfahren gemäß Anspruch 6, dadurch gekennzeichnet, daß zur Herstellung der metallisierten und strukturierten Flächen die Semi-Additiv-Technik oder die Additiv-Technik eingesetzt wird.

8. Kupferfolienfreie Mehrlagen-Leiterplatten für Feinleiter.

FIGUR 1

FIGUR 2

FIGUR 3